# EUROPÄISCHE PATENTSCHRIFT

(11) **EP 1 123 792 B1**
(45) Veröffentlichungstag und Bekanntmachung des Hinweises auf die Patenterteilung: **14.05.2003**
(21) Anmeldenummer: 01103121.8
(22) Anmeldetag: 09.02.2001
(51) Int. Cl.: B29C 45/14, H05K 7/00, H05K 5/02

(54) **Formgebend umspritzte, elektrische und/oder elektronische Komponente und Verfahren zur Herstellung**
Electric and/or electronic component encapsulated by an overmoulding shaped by injection and method for producing
Composant électrique et/ou électronique enrobé d'un surmoulage formé par injection et procédé de fabrication

(30) Priorität: 11.02.2000 DE 10006211; 11.02.2000 DE 20002435 U
(43) Veröffentlichungstag der Anmeldung: 16.08.2001
(73) Patentinhaber: Virant, Robert, 1211 Ljubljana-Smartno (SI)
(72) Erfinder: Virant, Robert, 1211 Ljubljana-Smartno (SI)
(74) Vertreter: Brehm, Hans-Peter

(56) Entgegenhaltungen:
- DE-A- 19 528 731
- DE-A- 19 900 632
- DE-U- 8 232 238
- DE-U- 8 232 239

## Beschreibung

Die vorliegende Erfindung betrifft eine formgebend umspritzte, elektrische und/oder elektronische Komponente. Ferner betrifft die Erfindung ein Verfahren zur Herstellung einer solchen Komponente. Weiterhin betrifft die Erfindung ein Zwischenprodukt, das bei diesem Verfahren eingesetzt werden kann.

Als elektrische und/oder elektronische Komponente kommen elektrische und/oder elektronische Bauteile, sowie aus solchen Bauteilen aufgebaute Schaltkreise in Betracht. Solche Schaltkreise können beispielsweise RC-Glieder oder LC-Glieder sein.

Die Erfindung erweist sich als besonders wertvoll in Verbindung mit druck- und/oder temperatur-empfindlichen elektrischen und/oder elektronischen Bauteilen. Hier seien beispielsweise Elektrolytkondensatoren und Spulen mit Ferritkern genannt.

Ohne das damit eine Beschränkung beabsichtigt ist, wird die Erfindung nachstehend mit Bezugnahme auf eine ausgewählte elektrische und/oder elektronische Komponente in Form eines Sperrkreises erläutert, der in Verbindung mit Heckscheiben-Antennen-Systemen in Kraftfahrzeugen eingesetzt wird. Bei diesem Sperrkreis handelt es sich um einen Kabelsperrkreis, der neben je zwei elektrischen Zuleitungen und Ableitungen zwei Spulen und zwei Kondensatoren aufweist. Jede Spule weist eine einlagige Wicklung aus vergleichsweise dickem Kupferdraht auf, in welche ein Ferritkern eingesetzt ist. Bei den Kondensatoren handelt es sich zum einen um einen kleinen Tantalkondensator und zum anderen um einen Elektrolytkondensator axialer Bauart, der eine axiale Länge größer/gleich 15 mm aufweist. Die Kontaktierung der einzelnen Bauteile untereinander und mit den elektrischen Zu- und Ableitungen erfolgt durch Krimpverbindungen.

Ein solcher Sperrkreis ist typischerweise in eine Kunststoffmasse eingebettet. Es resultiert ein durch formgebende Umspritzung erhaltener Kunststoffkörper mit vorgegebener Gestalt, in welchen die elektrischen und/oder elektronischen Bauteile und Komponenten vollständig eingebettet sind und aus welchem lediglich die elektrischen Zu- und Ableitungen herausragen. Bei diesem Körper kann es sich beispielsweise um einen Stab mit rechteckigem Querschnitt handeln.

Typischerweise ist ein solcher Kunststoffkörper mit wenigstens einem einstückig angeformten Befestigungsmittel, beispielsweise mit wenigstens einer einstückig angeformten Rastnase versehen, dessen/deren Teile ebenfalls aus dem Kunststoffkörper-Material bestehen. Vorzugsweise sind zwei, im Abstand zueinander angeordnete Befestigungsmittel/Rastnasen vorgesehen. Im Fall der Rastnasen kann jede Rastnase mehrere abstehende, einstückig angeformte und elastisch auslenkbare Rastnäsenflügel aufweisen.

Bei einer bekannten Ausführungsform besteht der Formkörper in welchen die elektronische und/oder elektrische Komponente eingebettet ist, sowie das oder die abstehenden Befestigungsmittel, beispielsweise zwei einstückig am Formkörper angeformte und von diesem abstehende Rastnasen aus dem gleichen Material. In diesem Falle müssen die für die Umspritzung verwendeten Kunststoffe nicht nur die elektrische und/oder elektronische Komponente sicher und dauerhaft einschließen und schützen, auch vor der Einwirkung von Feuchtigkeit, sondern sie müssen auch über viele Jahre hinweg die Funktionsfähigkeit der Befestigungsmittel/ Rastnase(n) gewährleisten, beispielsweise in einem Kraftfahrzeug über viele Jahre den Dauerschwingungsbeanspruchungen standhalten. Folglich werden Kunststoffe ausgewählt, die einerseits dauerhaft, inert, formund temperaturbeständig sind sowie andererseits erforderliche und bestimmte elastische Eigenschaften wie Streckspannung, Biegespannung, Biegefestigkeit, E-Modul und Dauerschwingungsfestigkeit aufweisen müssen. Häufig werden von der Kraftfahrzeugindustrie für diese Kunststoffe bestimmte Werkstoffe vorgeschrieben, wie beispielsweise HOSTAFORM C 52021 oder C 9021 ("HOSTAFORM" ist ein Warenzeichen der vorm. HOECHST AG) oder bestimmte Polyamide (PA 6.6) die von BASF AG unter den Handelsbezeichnungen ULTRAMID A oder ULTRAMID B vertrieben werden. Neben diesen Grundtypen können diese Werkstoffe auch in glasfaserverstärkter Version eingesetzt werden. Die Auswahl geeigneter Werkstoffe dieser Art ist in der Fachwelt bekannt. Bei diesen und anderen vergleichbaren, zu diesem Zweck eingesetzten Werkstoffen handelt es sich typischerweise um thermoplastische, im Spritzgußverfahren verarbeitbare Formmassen-Werkstoffe, die eine Zugestigkeit (nach DIN 53455) größer 42 N/mm² und einen Elastizitätsmodul (nach DIN 53457) größer 960 N/mm² aufweisen.

Typischerweise werden diese thermoplastischen Formmassen-Werkstoffe zur Erzeugung formgebender Umspritzungen durch Spritzgießen verarbeitet. Hierbei sind drastische Bedingungen erforderlich. Typischerweise wird HOSTAFORM C 9021 bei 207°C unter einem Spritzdruck von 690 bis 700 bar verarbeitet. Die Ultramid-Werkstoffe A3K bzw. B3K werden beispielsweise bei einer Schmelzentemperatur von 285°C bzw. 255°C und unter einem Spritzdruck von 800 bar bzw. 880 bar verarbeitet.

Im Rahmen der vorliegenden Erfindung wurde festgestellt, daß manche elektrische und/oder elektronische Bauteile und Komponenten unter diesen drastischen Bedingungen geschädigt werden. Besonders gefährdet sind Elektrolytkondensatoren, die eine bestimmte Baugröße übersteigen, beispielsweise Elektrolytkondensatoren axialer Bauart mit einer axialen Baulänge größer/gleich 15 mm. Temperaturen oberhalb 200°C können den zumeist flüssigen Elektrolyten schädigen. Spritzdrücke von 700 bar und mehr verursachen eine Verformung, insbesondere wenn die Baugröße des Elektrolytkondensators bestimmte Werte übersteigt.

Bei Ferriten für elektrische Spulen handelt es sich häufig um Sinterkörper aus ausgewählten ferromagnetischen Werkstoffen. Im Anschluß an die Sinterbehandlung werden ganz bestimmte Wärmebehandlungsschritte vorgenommen, um die magnetischen Eigenschaften hervorzurufen und zu stabilisieren. Auch solche Ferrite können bei erneuter Erwärmung auf 200°C und mehr geschädigt werden.

Bei den Zu- und Ableitungen der elektrischen und/oder elektronischen Komponenten handelt es sich typischerweise um isolierte elektrische Kabel, deren Kabelmantel häufig aus PVC-Material besteht. Typischerweise hier eingesetzte PVC-Materialien schmelzen oberhalb 85 bis 90°C. Im Kontakt mit 200°C-heißer Formmasse kann somit auch eine Schädigung dieser Isolierung auftreten.

Erfahrungsgemäß tritt bei Abkühlung der vorstehend genannten Formmassen-Werkstoffe eine Schwindung in einer Größenordnung von 3 Vol.-% und mehr auf. Bei ungleicher Massenverteilung, die gerade bei aus mehreren Bauteilen bestehenden Komponenten nicht zu vermeiden ist, verursacht diese Schwindung eine nachträgliche Verformung des Formkörpers. Eine zuverlässige Abhilfe ist recht aufwendig.

Davon ausgehend besteht ein Bedarf nach formgebend umspritzten, elektrischen und/oder elektronischen Bauteilen
- die in einen Werkstoff eingebettet sind, der diese Bauteile und Komponenten sicher und dauerhaft einschließt und schützt, auch vor der Einwirkung von Feuchtigkeit;
- wobei im Verlauf der Umspritzung dieser Bauteile und Komponenten eine Gefahr von deren Schädigung durch hohe Temperaturen und/oder hohe Drücke weitgehend oder völlig ausgeschlossen ist, auch im Falle von druckund temperaturempfindlichen Komponenten, wie Elektrolytkondensatoren und/oder Spulen mit Ferritkemen; und wobei
- von den diese umspritzten Bauteile und Komponenten einschließenden Formkörpern Befestigungsmittel abstehen, die auch den rauhen Betriebsbedingungen in einem Kraftfahrzeug über viele Jahre standhalten.

Das Dokument DE 195 28 731, nach dem die zweiteilige Form des Anspruchs 1 gewählt wurde, betrifft ein Verfahren zum Schützen von elektrischen, elektronischen, elektromechanischen und/oder mechanischen Bauteilen. Die Besonderheit besteht darin, dass die Bauteile unter Verwendung eines Spritzgießverfahrens mit einer Vergußmasse ummantelt werden. Gemäß einer besonders vorteilhaften Ausführungsform ist die Vergußmasse ein thermoplastischer Kunststoff, und insbesondere ein thermoplastischer Heißschmelzkleber. Hierdurch kann der Spritzgießvorgang im Niederdruckbereich, oder sogar auch ohne Druck durchgeführt werden, vorzugsweise in einem Druckbereich von 0 - 60 bar. Es wird als sehr vorteilhaft bezeichnet, wenn in die Vergußmasse Anschluss- und/oder Befestigungselemente, wie z.B. Flachstecker, Anschraublaschen, Koaxialanschlüsse usw. eingebracht werden. Diese Anschluss- und Befestigungselemente ermöglichen nach dem Vergießen eine definierte Aufnahme und Ableitung von Steck-, Druck- und/oder Ziehkräften. Erfahrungsgemäß werden solche Anschlussund Befestigungsmittel typischerweise aus Metall bestehen.

Das Dokument DE 82 32 238 U betrifft ein Gehäuse aus elastischem Kunststoff mit einem darin angeordneten elektrischen Bauelement, mit am Boden des Gehäuses angeformten Rastelementen mit seitlich abstehenden Rasthaken, mit denen das Gehäuse in einer Bohrung einer Platte dadurch fixierbar ist, dass die Rastelemente die Bohrung zum Teil durchdringen, und die seitlichen Rasthaken die Platte hintergreifen. Die Rastelemente sind einstückig am Gehäuse ausgebildet und bestehen aus dem Gehäusematerial.

Das Dokument DE 82 32 239 U betrifft ein Gehäuse aus elastischem Kunststoff mit einem darin angeordneten elektrischen Bauelement, das außen am Boden wenigstens zwei angeformte Rastelemente mit seitlich abstehenden Rastfingem aufweist, mit denen das Gehäuse in einer Bohrung einer Platte dadurch fixierbar ist, dass die Rastelemente die Bohrung zum Teil durchdringen, und die seitlichen Rastfinger die Platte hintergreifen. Die Rastelemente sind einstückig am Gehäuse ausgebildet und bestehen aus dem Gehäusematerial.

Das Dokument DE 94 00 585 U1 bezieht sich auf einen abgedichteten elektrischen Stecker, der für die Anwendung in Kraftfahrzeugen bestimmt sein kann. Der bekannte elektrische Stecker besteht aus einem Gehäuse, in dem die Steckerstifte mit nach außen geführten Anschlussleitungen festgelegt sind, insbesondere zur Konfektionierung von Kabelbäumen. Die Besonderheit besteht darin, dass der von Steckerstiften und Anschlussleitungen freie Gehäuseinnenraum mit einer Dichtmasse ausgefüllt ist, bei der es sich um einen Schmelzklebstoff auf Polyamid-Basis handeln kann, für den als geeignetes, beispielhaftes Material auch "MACROMELT" von der Firma Henkel angegeben ist.

Die Verarbeitung von "MACROMELT" ist in dem Beitrag "Vom Kleb- und Dichtstoff zum Formteil" in kleben und dichten ADHÄSION Jahrgang 37, 11/93, S. 35 - 37, angesprochen. Danach handelt es sich bei "MACROMELT" um Schmelzklebstoffe auf PA-Basis, die auf diversen Kunststoffen wie beispielsweise PE, PVC oder PA 66 gut haften. "MACROMELT" ist niedrigviskos. Diese Eigenschaft macht sich das Macromelt-Moulding-Verfahren zunutze. In einem dem Spritzguss verwandten Verfahren wird der erhitzte (zwischen 120 und 180°C) Schmelzklebstoff in ein Werkzeug gespritzt. Die dünnflüssige Schmelze ist geeignet, auch ohne hohen Druck filigrane Bauteile zu umspülen. Schon bei einem Druck zwischen fünf und zehn bar gelangt der Dichtstoff selbst in kleinste Zwischenräume, wie sie zum Beispiel bei Kabeldurchführungen gegeben sind. Der niedrige Druck hat zur Folge, dass das gesamte Verfahren besonders wirtschaftlich ist. Die Dimensionierung sowohl der Maschine als auch der Werkzeuge kann auf diese relativ niedrigen Belastungen ausgelegt werden. Zusätzlich kann "MACROMELT" auch die Funktionen von Formteilen übernehmen; in einzelnen Anwendungsfällen können so bislang eingesetzte Kunststoffteile substituiert werden.

Davon ausgehend, besteht das, der vorliegenden Erfindung zugrundeliegende technische Problem (die Aufgabe) darin, für eine formgebend umspritzte, elektrische und/oder elektronische Komponente, die in einen Formkörper aus festem thermoplastischen Kunstharz eingebettet ist, das aus einer, unter Niederdruckbedingungen verarbeitbaren Hotmelt-Formmasse auf Polyamid-Basis erhalten worden ist, ein alternatives Befestigungsmittel bereitzustellen, mit welchem der Formkörper einfach, sicher, dauerhaft und zuverlässig an einem vorgegebenen Substrat befestigt werden kann, etwa auch an einem solchen Substrat, das innerhalb der Karosserie eines Kraftfahrzeugs untergebracht ist.

Die erfindungsgemäße Lösung dieses technischen Problems ist eine formgebend umspritzte Komponente mit der Gesamtheit der Merkmalskombination nach Anspruch 1.

Vorteilhafte Ausgestaltungen und Weiterbildungen der Erfindung ergeben sich aus den Unteransprüchen.

Die Ansprüche 17 und 18 und die darauf rückbezogenen Ansprüche betreffen je ein Verfahren zur Herstellung einer Ausführungsform einer solchen formgebend umspritzten Komponente.

Das Bauteil oder die Komponente ist in einen durch formgebende Umspritzung erhaltenen Formkörper eingebettet, der aus einem festen, thermoplastischen Kunstharz besteht, das aus einer, unter Niederdruckbedingungen verarbeitbaren Hotmelt-Formmasse auf Polyamidbasis erhalten worden ist. Derartige Hotmelt-Formmassen sind in der Fachwelt bekannt und werden beispielsweise von der Firma OptiMel Schmelzgusstechnik GmbH & Co.KG (ein Unternehmen der Henkel-Gruppe) unter der Handelsbezeichnung "MACROMELT" oder von MYDRIN TRL, 07003 Privas Cedex, Frankreich, unter der Handelsbezeichnung "THERMELT" oder von WEVO-CHEMIE GMBH + CO, D-73760 Ostfildem unter der Handelsbezeichnung "WEVO-TS ...." vertrieben. Zur Verarbeitung wird die schmelzflüssige, typischerweise eine Temperatur von etwa 200 bis 220°C aufweisende
Hotmelt-Formmasse unter einem Spritzdruck von etwa 5 bis 20 bar, vorzugsweise 5 bis 10 bar in ein Moulding-Werkzeug eingeführt, in welchem wenigstens ein Formhohlraum ausgespart ist, der an die Kontur des bei der Umspritzung angestrebten Formkörpers angepaßt ist. Wegen des niedrigen Spritzdruckes können vergleichsweise einfach aufgebaute Werkzeuge aus Aluminium verwendet werden. Vergleichbare Hotmelt-Schmelzkleber sind in der Vergangenheit vor allem zur Abdichtung von Kabeldurchführungen an Steckergehäusen und anderen Gehäusen eingesetzt worden.

Die aus solchen Hotmelt-Formmassen oder -Schmelzklebern erhältlichen Formkörper weisen je nach Typ typischerweise eine Zugfestigkeit (bei 20°C) von 2,5 bis maximal etwa 11,0 N/mm² (OPTIMEL OM 646) auf. Diese Festigkeitswerte sind ungenügend für abstehende bzw. freitragende Befestigungsmittel, mit deren Hilfe solche Formkörper an einem vorgegebenen Substrat festlegbar sind, das gegebenenfalls auch den notorisch rauhen Bedingungen innerhalb der Karosserie eines Kraftfahrzeugs (Stöße, Schwingungen, Temperaturwechsel) ausgesetzt ist. Es ist deshalb nicht möglich, diese Befestigungsmittel ebenfalls aus der Hotmelt-Formmasse zu fertigen und einstückig mit dem restlichen Formkörper zu verbinden.

Stattdessen wird mit der vorliegenden Erfindung vorgeschlagen, diese aus der unter Niederdruckbedingungen verarbeitbaren Hotmelt-Formmasse auf Polyamid-Basis erhaltenen Formkörper zusätzlich mit wenigstens einem von dem Formkörper abstehenden Befestigungsmittel zu versehen, das aus einem anderen, thermoplastischen Formmassen-Werkstoff besteht, der eine Zugfestigkeit (nach DIN 53455) größer 42 N/mm² und einen Elastizitätsmodul (nach DIN 53457) größer 960 N/mm² aufweist. Die aus solchen Werkstoffen bestehenden Befestigungsmittel weisen ausreichende mechanische Eigenschaften, ausreichende elastische Eigenschaften und ausreichende Dauerschingfestigkeit auf, um eine einfache, sichere, dauerhafte und zuverlässige Befestigung der die elektrische und/oder elektronische Komponente beinhaltenden Formkörper beabstandet, also in freitragender Weise an einem vorgegebenen Substrat zu gewährleisten. Insbesondere kann diese Befestigung über viele Jahre auch unter den notorisch rauhen Bedingungen gewährleistet werden, wie sie typischerweise innerhalb der Karosserie eines Kraftfahrzeugs auftreten.

Zu geeigneten Werkstoffen dieser Art gehören beispielsweise ausgewählte Polystyrole, Styrol/Acrylnitril-Copolymerisate (SAN), Acrylnitril/Butadien/ Styrol-Copolymere (ABS), Hart-PVC, Polytetrafluorethylen, Polymethylmethacrylate (MMA), Acetal-Copolymerisate (wie sie unter der Handelsbezeichnung "HOSTAFORM" vertrieben werden), Polyamide (etwa PA 6, PA 6.6, PA 11, PA 12), Polycarbonate, Polyester und Polysulfone.

Vorzugsweise werden solche in Spritzgußverfahren verarbeitbare Formmassen-Werkstoffe eingesetzt, die eine Zugfestigkeit (nach DIN 43455) größer 54 N/mm² und einen Elastizitätsmodul (nach DIN 53457) größer 1200 N/mm² aufweisen. Mit abstehenden Befestigungsmitteln aus diesen Werkstoffen wird eine noch sicherere und daherhaftere Befestigung der Formkörper auch unter schwierigen Umgebungsbedingungen (Dauerschwingungsbeanspruchung) erhalten.

Besonders bevorzugte Formmassen-Werkstoffe zur Erzeugung der abstehenden Befestigungsmittel sind "HOSTAFORM C 9021 oder C 52021", sowie Polyamide (vom Typ PA 6.6) die von BASF unter der Handelsbezeichnung ULTRAMID, Typen A oder B vertrieben werden.

Mit diesen Werkstoffen werden eine besonders hohe mechanische Festigkeit und Dauerhaftigkeit, gutes elastisches Verhalten, hohe Dauerschwingfestigkeit, hohe Temperaturwechselbeständigkeit und gute Benetzbarkeit und Haftung gegenüber dem bekannten Hotmelt-Formmassen auf Polyamid-Basis erhalten.

Die aus diesen Formmassen-Werkstoffen bestehenden Befestigungsmittel bilden eine Brücke zwischen dem festzulegenden Formkörper aus Hotmelt-Formmasse und einem als Basis, Halterung oder Untergrund dienenden Substrat. Folglich sind diese Befestigungsmittel mit einem Ende dauerhaft im oder am Formkörper festgelegt und mit einem anderen, gegenüberliegenden Ende an dem Substrat festlegbar. Das abstehende Befestigungsmittel kann vorzugsweise ein Stab, ein Stempel, ein Fuß, ein Profilstück, eine Feder für eine Nut/Feder-Verbindung oder ein sonstiges Rastmittel für eine Rastverbindung sein, das an einer angepaßten Aufnahme in einem Substrat festlegbar ist. Typischerweise und vorzugsweise erfolgt die Festlegung mit Hilfe einer Rastverbindung und/oder einer sonstigen, nach elastischer Verformung wirksamen formschlüssigen Maßnahme. Das zum Formkörper beabstandete Ende des länglichen Befestigungsmittels weist hierzu eine, an eine Ausnehmung im Substraßt angepaßte Gestalt auf, beispielsweise in Form eines einrastbaren Kopfes, einer Feder für eine Nut/Feder-Verbindung oder eines sonstigen Rastmittels für eine Rastverbindung.

Besonders bevorzugt ist dieser Abschnitt des Befestigungsmittels als Rastnase ausgebildet. Vorzugsweise ist eine solche Rastnase mit abstehenden, einstückig angeformten und elastisch auslenkbaren Rastnasenflügeln versehen, die beim Hindurchdrücken durch eine Offnung im Substrat elastisch verformt werden, anschließend jedoch wieder ihre ursprüngliche Ausrichtung einnehmen und dabei den Rand der Öffnung hintergreifen und sich derartig spreizen, daß eine erneute Trennung der Rastnase - ohne deren Zerstörung - vom Substrat ausgeschlossen ist.

Die Befestigung des Befestigungsmittels am oder im Formkörper aus Hotmelt-Formmasse kann in unterschiedlicher Weise erfolgen. Nach einer Alternative kann das Befestigungsmittel einstückig mit einer größeren Platte, einem Wandabschnitt oder einem Gehäuseabschnitt verbunden sein, der ebenfalls aus dem Befestigungsmittel-Material besteht und dauerhaft an dem Formkörper aus Hotmelt-Formmasse anliegt. Nach einer anderen Alternative kann das überbrückende Befestigungsmittel an dem zum Substratende entfernten Ende mit einem dort einstückig angeformten Verankerungselement versehen sein, das in die Hotmelt-Formmasse eingebettet ist und auf Grund von deren Kohäsion formschlüssig und dauerhaft innerhalb der Hotmelt-Formmasse festgehalten bzw. verankert ist. Zusätzlich ist eine solche Materialauswahl zweckmäßig, die eine gute Haftung zwischen Hotmelt-Formmasse auf Polyamid-Basis und dem Befestigungsmittel-Werkstoff gewährleistet.

Diese einstückig mit dem restlichen Befestigungsmittel verbundenen und aus dem gleichen Formmassen-Werkstoff bestehenden Verankerungselemente können verschiedene Gestalt aufweisen, die einen sicheren Formschluß und damit eine dauerhafte Verankerung innerhalb der Hotmelt-Formmasse gewährleisten. Vorzugsweise kann diese Gestalt entsprechen einer geschlossenen Schleife, einem Stab mit einstückig angeformten Querstreben, einem Fuß mit endständig angeformtem Teller oder dieses Verankerungselement kann ein sich in das Innere des Formkörpers aus Hotmelt-Formmasse hinein kegelförmig oder kugelförmig erweiternder Körper sein.

Im Falle eines länglichen stabförmigen Formkörpers aus Hotmelt-Formmasse sind vorzugsweise zwei, im Abstand zueinander angeordnete und in die gleiche Richtung abstehende Befestigungsmittel vorgesehen, die je benachbart zu einem Formkörperende angebracht sind. Bei einem länglichen, stabförmigen Formkörper sind vorzugsweise zwei im Abstand zueinander angeordnete Rastnasen vorgesehen, die je benachbart zu einem Stabende angebracht sind.

Zur Befestigung der Rastnase am Formkörper kann die Rastnase mit einem einstückig angeformten Verankerungsteil versehen sein, das im Verlauf des Vergießens des Formkörpers in die Hotmelt-Formmasse eingebettet wird. Alternativ kann an der Rastnase einstückig eine geschlossene Schleife aus Rastnasenmaterial angeformt sein. Zur Befestigung kann diese Schleife in den Formkörper eingebettet werden oder der fertige Formkörper kann nachträglich in diese Schleife eingesetzt werden.

Nach einer alternativen, mehr bevorzugten Ausführungsform ist eine solche Rastnase einstückig an einem, aus dem Rastnasenmaterial bestehen-Gehäuseteil angeformt, an welchem die Hotmelt-Formmasse anliegt,in welche die Komponente eingebettet ist. Ein solches Gehäuseteil kann dann einen Teil der Oberfläche des fertigen Formkörpers bilden. Beispielsweise kann es sich bei einem solchen Gehäuseteil um eine ebene Platte handeln, welche eine Wand des Formkörpers bildet.

Besonders bevorzugt bildet dieses Gehäuseteil eine, im Querschnitt U-förmige Schiene von deren Rücken bzw. Steg die dort einstückig angeformte Rastnase nach außen absteht. Innerhalb des von der U-förmigen Schiene umgrenzten Hohlraums befindet sich die Hotmelt-Formmasse, in welche die Komponente eingebettet ist. Zusammen mit der oder den einstückig angeformten Rastnase(n) kann eine solche U-förmige Schiene in einem vorausgegangenen Fertigungsschritt durch Spritzgießen aus herkömmlichem Formmassen-Werkstoff gefertigt werdem und bildet dann ein Zwischenprodukt zum Einsatz beim erfindungsgemäßen Verfahren.

Eine solche Schiene kann an ihrer Innenfläche mit Rillen und/oder Vorsprüngen versehen sein, um einen Formschluß mit dem Formkörper aus Hotmelt-Formmasse zu erzeugen. Ferner kann an der Innenfläche jedes Schenkels der U-förmigen Schiene einstückig je ein leicht auslenkbarer Streifen angeformt sein, der beim Einlegen der Komponenten in die Schiene ausgelenkt wird, jedoch anschließend die Komponente in einer gewünschten Anordnung hält.

Mit Hilfe einer solchen U-förmigen Schiene wird letztlich ein Formkörper erhalten, der an drei von vier Längsflächen von thermoplastischen, Formmassen-Werkstoff hoher Festigkeit und Steifigkeit begrenzt ist und deshalb weitestgehend die mechanischen Eigenschaften dieses Werkstoffes aufweist. Auch die Rastnase(n) bestehen aus diesem thermoplastischen Formmassen-Werkstoff und weisen deshalb die bekannten, von der Kraftfahrzeugindustrie geforderten Eigenschaften auf.

In diesem Falle weist das Verfahren zur Herstellung einer formgebend umspritzten, elektrischen und/oder elektronischen Komponente wenigstens nachstehende Verfahrensschritte auf:
- es wird eine im Querschnitt U-förmige Schiene aus einem thermo-plastischen Formmassen-Werkstoff bereitgestellt, der eine Zugfestigkeit (nach DIN 53455) größer 42 N/mm² und einen Elastizitätsmodul (nach DIN 53457) größer 960 N/mm² aufweist und von deren Rücken bzw. Steg wenigstens eine Rastnase absteht, die aus dem gleichen Formmassen-Werkstoff besteht und einstückig angeformt ist;
- in den von der Schiene umgrenzten Hohlraum wird die Komponente eingelegt, deren elektrische Zu- und Ableitungen aus der Schiene herausgeführt sind;
- es wird ein verschließbares Moulding-Werkzeug bereitgestellt, das einen angepaßten Formhohlraum zur Aufnahme der Schiene mit der oder den abstehenden Rastnase(n) aufweist;
- die Anordnung aus Schiene mit darin eingelegter Komponente wird in diesen Formhohlraum eingebracht;
- das Moulding-Werkzeug wird verschlossen;
- in den von der Schiene umschlossenen Innenraum wird unter Niederdruckbedingungen schmelzflüssige Hotmelt-Formmasse
- nach ausreichender Verfestigung der Hotmelt-Formmasse wird das Moulding-Werkzeug geöffnet und das so gebildete Produkt entnommen.

Im Falle einer Verwendung einzelner, separater Befestigungsmittel, insbesondere Rastnasen, je mit einstückig angeformtem Verankerungselement, wird das vorstehend erläuterte Verfahren in der Weise abgeändert, daß - anstelle der Einbringung einer vorgefertigten U-förmigen Schiene mit darin eingelegter Komponente - diese Komponente in den Formhohlraum des Moulding-Werkzeugs eingebracht und darin gezielt angeordnet/festgelegt wird, weiterhin am Moulding-Werkzeug ein oder mehrere Befestigungsmittel, insbesondere Rastnasen so abdichtend angebracht werden, daß deren Verankerungselement je in den Formhohlraum hineinragt. In diesem Falle ist ein Verfahren mit nachstehenden Verfahrensschritten vorgesehen:
- es werden einzelne, seperate Befestigungsmittel, insbesondere in der Form von Rastnasen bereitgestellt, die je mit einem einstückig angeformten Verankerungselement versehen sind, und die je aus einem thermoplastischen Formmassen-Werkstoff bestehen, der eine Zugfestigkeit (nach DIN 53455) größer 42 N/mm² und einen Elastizitätsmodul (nach DIN 53457) größer 960 N/mm² aufweist;
- es wird ein verschließbares Moulding-Werkzeug bereitgestellt, das für die Verarbeitung von Hotmelt-Formmassen geeignet ist und das einen angepaßten Formhohlraum zur Aufnahme der elektrischen und/oder elektronischen Komponente aufweist;
- diese Komponente wird in den Formhohlraum eingelegt und darin in bestimmter Weise angeordnet und festgelegt;
- an einem Werkzeugteil werden das oder die Befestigungsmittel, insbesondere die Rastnase(n) abdichtend so angebracht, daß je deren Verankerungselement nach Verschließen des Werkzeugs in den Formhohlraum hineinragt;
- unter Niederdruckbedingungen wird schmelzflüssige Hotmelt-Formmasse in den Formhohlraum eingeführt und damit die darin befindliche Komponente sowie das/die Verankerungselement(e) umspritzt; und
- nach ausreichender Verfestigung der Hotmelt-Formmasse wird das Moulding Werkzeug geöffnet, und das Produkt entnommen.

Anschließend können übliche Zuricht- und Reinigungsarbeiten durchgeführt werden, beispielsweise zur Beseitigung von Angußrückständen.

Vorteilhafterweise kann das erfindungsgemäße Verfahren eine weitere Besonderheit dieser Hotmelt-Formmasse ausnutzen. Auch noch bei niedrigen Temperaturen zwischen etwa 120 und 140°C ist die Schmelze so dünnflüssig, daß sie auch ohne Anwendung von hohem Druck filigrane Bauteile umspült, auch in kleinste Zwischenräume und Spalte eindringt und kleinste Hohlräume vollständig ausfüllt. Selbst wenn die Schmelze mit einer Temperatur von etwa 210 bis 200°C in das Moulding-Werkzeug eingeführt wird, kann durch entsprechende Bauform des Werkzeugs und durch entsprechende Wahl der Anordnung, der Geometrie und der Größe des Angußkanals oder der Angußkanäle eine rasche Abkühlung auf Temperaturen zwischen etwa 120 und 140°C erreicht werden, bevor die Schmelze das zu umspritzende Bauteil kontaktiert. Auf diese Weise werden nicht nur hohe Drücke vermieden, welche zu einer Verformung des Bauteils, insbesondere bei Elektrolytkondensatoren führen könnte, sondern es werden auch solch hohe Temperaturen vermieden, die zu einer thermischen Schädigung des Bauteils führen könnten.

Auf diese Weise kann beispielsweise ein formgebend umspritzter Elektrolytkondensator, insbesondere ein Elektrolytkondensator in axialer Bauform mit einer axialen Länge größer/gleich 15 mm erhalten werden, der in eine schützende Hülle aus Hotmelt-Formmasse eingebettet ist und mit den vorstehend erläuterten Befestigungsmittel(n), insbesondere Rastnase(n) versehen ist. Die Umspritzung nach dieser Vergußtechnik erfordert nur einen niedrigen Druck von etwa 5 bis 10 bar. Beim Kontakt mit dem Kondensator weist die Schmelze nur noch eine Temperatur von etwa 120 bis 140°C auf. Eine Schädigung des Elektrolytkondensators kann sicher ausgeschlossen werden.

Vorzugsweise kann in einem solchen Falle ein solches Moulding-Werkzeug verwendet werden, das aufgrund seiner Bauart und aufgrund der Anordnung, der Geometrie und der Größe des Angußkanals oder der Angußkanäle eine rasche Abkühlung der eingeführten, schmelzflüssigen Hotmelt-Formmasse gewährleistet, bevor diese die elektrischen und/oder elektronischen Bauteile der eingelegten Komponente kontaktiert. Beispielsweise kann die zugeführte Schmelze eine Temperatur von etwa 210 bis 200°C aufweisen, und aufgrund dieser besonderen, eine rasche Abkühlung fördernden Bauweise wird die Schmelze innerhalb des Moulding-Werkzeugs auf etwa 130°C abgekühlt, bevor diese immer noch fließfähige Formmasse die Bauteile der eingelegten Komponente kontaktiert.

Nach einer weiteren, bevorzugten Ausführungsform kann das Moulding-Werkzeug aus einer Al/Cu-Legierung bestehen, die bis zu 1,5 % Cu enthält. Eine solche Al/Cu-Legierung weist ein besonders hohes Wärmeleitvermögen auf und führt die Wärme der eingeführten Schmelze besonders rasch ab.

Die Verwendung von unter Niederdruckbedingungen vergießbarer Hotmelt-Formmasse zum Umspritzen der Komponente, sowie die zusätzlichen Maßnahmen zur raschen Absenkung der Temperatur der in das Werkzeug eingeführten Schmelze verhindern jegliche Schädigung der Bauteile der Komponente durch Einwirkung hoher Temperatur und/oder hoher Drücke. Wenn zusätzlich eine Schiene aus herkömmlichem, hartem und dauerhaftem Formmassen-Werkstoff den fertigen Formkörper an drei von vier Längsflächen begrenzt, werden praktisch die mechanischen Eigenschaften der bekannten Formkörper erhalten. Dies gilt auch für die Befestigungsmittel, insbesondere die Rastnase(n) zur Befestigung der Formkörper.

Nachstehend wird die Erfindung mehr im einzelnen anhand bevorzugter Ausführungsformen mit Bezugnahme auf die Zeichnungen erläutert; die letzteren zeigen:
- Figur 1: in einer Schrägansicht einen Sperrkreis;
- Figur 2: in einer schematischen Seitenansicht ein vorgefertigtes Gehäuseteil mit zwei Rastnasen;
- Figur 3: eine Schnittansicht längs der Schnittlinie 3-3 aus Figur 2;
- Figur 4: eine Schnittansicht eines abgewandelten Gehäuseteils;
- Figur 5: eine Draufsicht von unten auf das Gehäuseteil nach Figur 2;
- Figur 6: eine Draufsicht von unten entsprechend Figur 5, jedoch mit eingelegtem Sperrkreis;
- Figur 7: eine Draufsicht von unten auf das fertige Produkt;
- Figur 8: eine Schnittansicht längs der Schnittlinie 8-8 aus Figur 7;
- Figuren 9a bis 9d: in schematischen Seitenansichten verschiedene Rastnasen mit unterschiedlichen, je einstückig angeformten Verankerungselementen;
- Figur 10: in einer schematischen Schnittansicht einen Formkörper aus Hotmelt-Formmasse, in den ein Sperrkreis eingebettet ist und von dessen Oberseite zwei aus anderem Formmassen-Werkstoff bestehende Rastnasen abstehen, deren Verankerungselemente ebenfalls in den Formkörper eingebettet sind; und
- Figur 11: in einer schematischen Schrägansicht ein weiteres erfindungsgemäßes Produkt, nämlich einen formgebend umspritzten Elektrolykondensator mit abstehendem Befestigungsmittel.

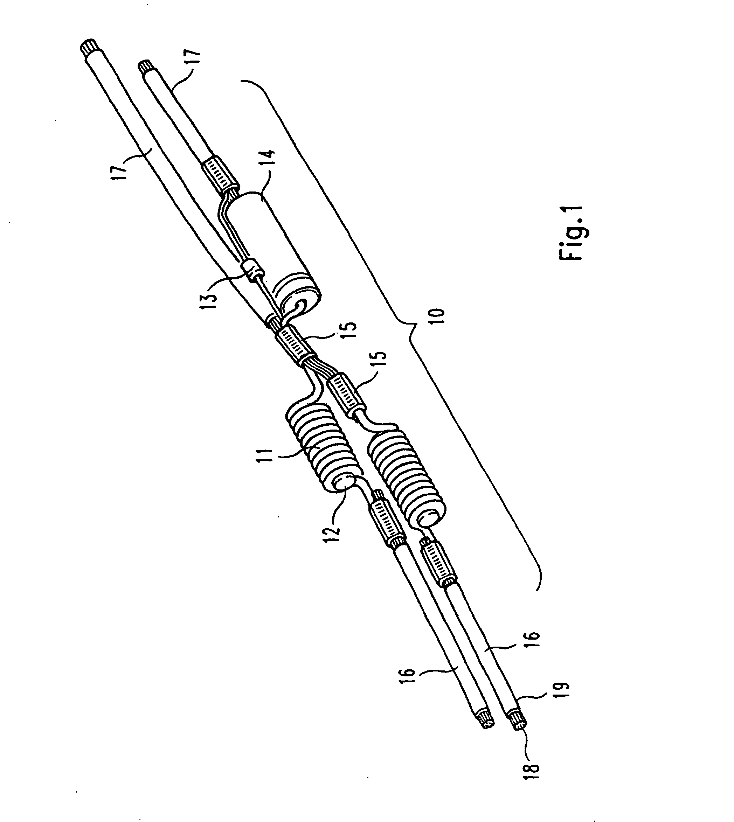

Figur 1 zeigt in einer Schrägansicht eine beispielhafte elektrische und/ oder elektronische Komponente 10, hier in Form eines Sperrkreises für ein Heckscheiben-Antennen-System. Diese Komponente 10 umfaßt zwei Spulen 11 um die Hochfrequenz, die zum Radioempfang aus dem Heizfeld der Heckscheibe ausgekoppelt wird, vom Heizgleichstrom zu trennen. Jede Spule 11 ist um einen Ferritkern 12 gewickelt. Als weitere elektrische und/oder elektronische Bauteile sind ein Tantalkondensator 13 und ein Elektrolytkondensator 14 vorhanden. Diese Kondensatoren 13, 14 dienen einerseits zur Unterdrückung von Störeinstrahlungen aus dem Bordnetz und andererseits zur Schaffung einer definierten HF-Masse. Die Kontaktierung dieser Bauteile erfolgt ausschließlich über Krimp-Verbindungen 15. Diese Komponente 10 verfügt über zwei elektrische Zuleitungen 16 sowie zwei elektrische Ableitungen 17. Jede Zu- und Ableitung umfaßt einen elektrischen Leiter 18, der mit Hilfe eines Kabelmantels 19 elektrisch isoliert ist.

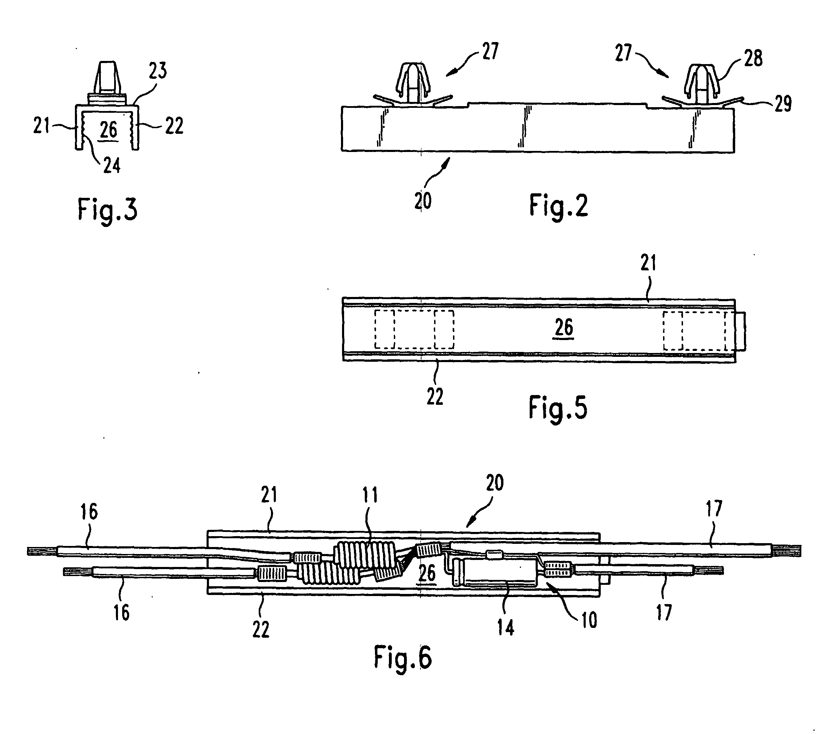

Nach einer bevorzugten Ausgestaltung der vorliegenden Erfindung wird die Komponente 10 in ein vorgefertigtes Gehäuseteil 20 eingelegt, das schematisch in den Figuren 2, 3 und 5 dargestellt ist. Bei diesem Gehäuseteil 20 handelt es sich um eine im Querschnitt U-förmige Schiene mit den beiden Schenkeln 21 und 22, die über einen Steg oder Rücken 23 miteinander verbunden sind. Die Innenseite der Schenkel 21, 22 kann mit Vorsprüngen 24 versehen sein, um einen Formschluß mit der einzubringenden Hotmelt-Formmasse zu erzeugen. Gemeinsam begrenzen der Steg 23 und die Schenkel 21 und 22 einen Hohlraum 26, in welchen die Komponente 10 eingelegt werden kann.

Auf dem Rücken 23 des Gehäuseteils 20 sitzen zwei Rastnasen 27, die dort einstückig angeformt sind und ebenfalls aus dem Gehäuseteil-Material bestehen. In an sich bekannter Weise weist jede Rastnase 27 abstehende, einstückig angeformte und elastisch auslenkbare Rastnasenflügel 28 und 29 auf. Die Rastnasenflügel 28 dienen zum Eingriff in eine Rastbohrung an einem - nicht dargestellten - Substrat, an welchem das Gehäuseteil 20 mit Hilfe der Rastnasen 27 festgelegt werden soll. Die vergleichsweise großflächigen Rastnasenflügel 29 dienen zur federnden Abstützung des Gehäuseteils 20 an diesem Substrat.

Zusammen mit den einstückig angeformten Rastnasen 27 wird das Gehäuseteil 20 typischerweise durch Spritzgießen erzeugt. Bei einer praktischen Ausführungsform handelt es sich um eine gerade, längliche, U-förmige Schiene mit einer Länge von etwa 90 mm, einer Höhe von etwa 11 mm, einer Breite von etwa 14 mm und mit geraden ebenen Wandabschnitten, die eine Wandstärke von etwa 1,0 bis 1,5 mm aufweisen. Die Rastnasen 27 haben typischerweise eine Höhe von 10 mm. Die Auswahl des Werkstoffes wird neben der grundsätzlich geforderten Stabilität, Dauerhaftigkeit, Schlagfestigkeit, Formbeständigkeit und Temperaturbeständigkeit vor allem durch die elastischen Eigenschaften der Rastnasen bestimmt.
Für diese wird je eine hohe Streckspannung, Biegespannung, Biegefestigkeit, ein hoher E-Modul (auf Zugbeanspruchung) sowie hohe Dauerschwingfestigkeit gefordert. Aufgrund der Vorgaben der Kraftfahrzeugindustrie sind bekannte, mit solchen Rastnasen versehene Formkörper, die nach dem formgebenden Umspritzen von elektrischen und/oder elektronischen Komponenten zum Einsatz im Kraftfahrzeug erhalten werden, typischerweise aus HOSTAFORM C 52021 oder C 9021 gefertigt worden; hierbei handelt es sich um extrem leicht fließende Spritzgußtypen für komplizierte dünnwandige Präzisionsteile. Bei Bedarf können neben diesen Grundtypen mit Glasfasern verstärkte Spritzgußtypen für Formteile mit sehr hoher Festigkeit und Steifheit, sowie erhöhter Härte vorgesehen werden. Als alternative Werkstoffe werden für diesen Zweck auch ausgewählte Polyamide vom Typ PA 6.6 eingesetzt; geeignete Typen werden von BASF AG unter der Handelsbezeichnung ULTRAMID, hier Typen A und B vertrieben. Ferner sind auch ausgewählte Werkstoffe aus Hart-PVC, Polyester und Polysulfon gut geeignet. Diese und andere, vergleichbare und für diesen Zweck eingesetzte Werkstoffe werden im Rahmen dieser Unterlagen als thermoplastische Formmassen-Werkstoffe bezeichnet, die eine Zugfestigkeit (nach DIN 53455) größer 42 N/mm² und einen Elastizitätsmodul (nach DIN 53457) größer 960 N/mm² aufweisen. Das vorstehend beschriebene Gehäuseteil 20 mit den beiden einstückig angeformten Rastnasen 27 besteht insbesondere aus HOSTAFORM C 9021.

Die Figur 6 zeigt eine Anordnung, bei welcher die Komponente 10 in den offenen Hohlraum 26 des Gehäuseteils 20 eingelegt ist. Die Zuleitungen 16 sowie die Ableitungen 17 ragen je über die endständigen Stirnflächen des Gehäuseteiles 20 hinaus.

Die Figur 4 zeigt in einer Schnittansicht eine abgewandelte Ausführungsform des Gehäuseteils 20. Hier ist an jeder Innenfläche der Stege 21 und 22 einstückig je ein leicht nach innen ablenkbarer Streifen 25 angeformt. Beim Einlegen der Komponente 10 in den von der U-förmigen Schiene begrenzten Hohlraum 26 werden diese Streifen 25 leicht ausgelenkt, halten jedoch anschließend die Komponente 10 innerhalb des Hohlraumes 26 in der gewünschten Anordnung.

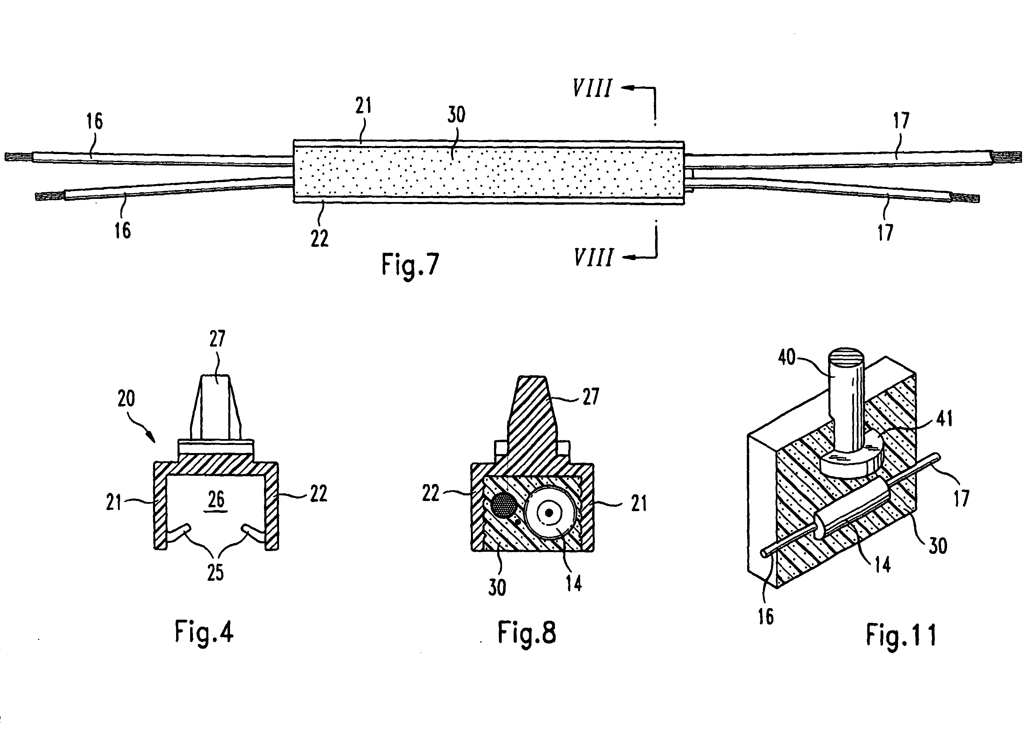

In einem weiteren Verfahrensschritt wird der nach Einlegen der Komponente 10 in den Hohlraum 26 des U-förmigen Gehäuseteils (entsprechend der Anordnung nach Figur 6) verbleibende freie Raum mit schmelzflüssiger Hotmelt-Formmasse ausgegossen. Dies geschieht innerhalb eines verschließbaren Moulding-Werkzeugs, das einen Formhohlraum aufweist, der an das Einlegen der Anordnung nach Figur 6 angepaßt ist. Die schmelzflüssige Hotmelt-Formmasse wird typischerweise aus einem entsprechenden Vorrat mit einer Temperatur mit etwa 200 bis 210°C zugeführt und unter einem Druck von vorzugsweise 5 bis 10 bar in das Moulding-Werkzeug eingeführt. Innerhalb des Moulding-Werkzeugs erfolgt eine rasche Abkühlung, so daß die immer noch schmelzflüssige Hotmelt-Formmasse die Bauteile 11 und 14 mit einer Temperatur von etwa 130°C kontaktiert. Nach Abkühlung und Verfestigung der Hotmelt-Formmasse wird das schematisch in Figur 7 dargestellte Produkt erhalten, wobei die erstarrte Hotmelt-Formmasse mit dem Bezugszeichen "30" gekennzeichnet ist. Die Figur 8 zeigt eine schematische Schnittdarstellung dieses Produktes.

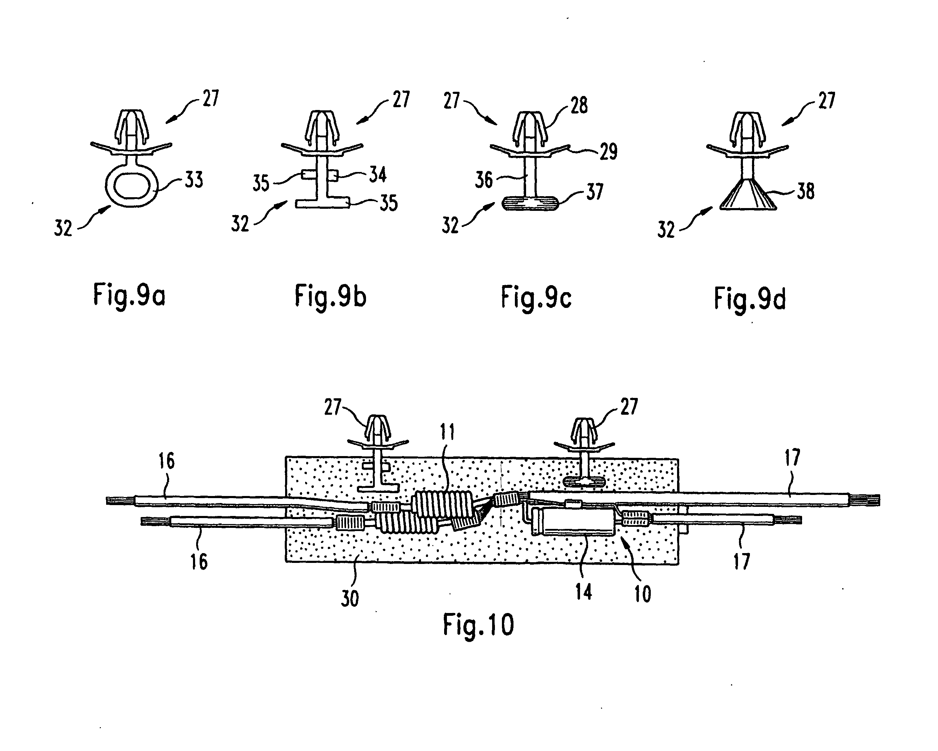

Anstelle eines Gehäuseteils mit einstückig angeformten Befestigungsmitteln, insbesondere Rastnasen, können auch einzelne separate Befestigungsmittel, insbesondere Rastnasen verwendet werden, die je aus dem thermoplastischen Formmassen-Werkstoff hoher Festigkeit und hoher Elastizität bestehen, und je mit einem einstückig angeformten Verankerungselement versehen sind. Derartige Rastnasen sind in den Figuren 9a bis 9d dargestellt; ersichtlich hat in
- Fig. 9a: dieses Verankerungselement 32 die Gestalt einer geschlossenen Schleife 33;
- Fig. 9b: dieses Verankerungselement 32 die Gestalt eines Stabes 34 mit einstückig angeformten Querstreben 35;
- Fig. 9c: dieses Verankerungselement 32 die Gestalt eines Fußes 36 mit endständig angeformtem Teller 37;
- Fig. 9d: dieses Verankerungselement 32 die Gestalt eines kegelförmigen Körpers 38, der sich in das Innere des Formkörpers hinen erweitert.

Die Figur 10 zeigt ein alternatives erfindungsgemäßes Produkt. Ein Sperrkreis 10 ist in einen Formkörper aus festem, thermoplastischen Kunstharz 30 eingebettet, das aus einer, unter Niederdruckbedingungen verarbeitbaren Hotmelt-Formmasse auf Polyamid-Basis erhalten worden ist. Von der Oberseite des Formkörpers stehen zwei Rastnasen 27 ab, die aus einem anderen, thermoplastischen Formmassen-Werkstoff bestehen, der eine Zugfestigkeit (nach DIN 53455) größer 42 N/mm² und einen Elastizitätsmodul (nach DIN 53457) größer 960 N/mm² aufweist. Jede Rastnase 27 ist mit einem einstückig angeformten Verankerungselement 32 versehen, hier mit einem Fuß 36, der mit einem endständig angeformten Teller 37 versehen ist, der seinerseits in den Formkörper aus Kunstharz 30 eingebettet ist.

Die Figur 11 zeigt in einer schematischen Schrägansicht ein weiteres erfindungsgemäßes Produkt. Hier ist ein einzelner Elektrolykondensator 14 mit Hotmelt-Formmasse formgebend umspritzt worden. Das fertige Produkt besteht aus einem quaderförmigen Formkörper 31 aus fester Hotmelt-Formmasse 30 in welche ein Elektrolytkondensator 14 von axialer Bauart mit einer axialen Baulänge größer/gleich 15 mm vollständig eingebettet ist. Je eine Zuleitung 16 zu dem Elektrolytkondensator 14 sowie eine Ableitung 17 von dem Elektrolytkondensator 14 führen aus dem Formkörper 31 heraus. Als abstehendes Befestigungsmittel dient ein zylindrischer Stab 40, an dessen einem Ende einstückig eine großflächige Scheibe 41 angeordnet ist, die in die feste Hotmelt-Formmasse eingebettet ist und als Verankerungselement für das Befestigungsmittel dient. Der Stab 40 und die Scheibe 41 bestehen aus dem vorstehend erläuterten Formmassen-Werkstoff hoher Festigkeit und hoher Elastizität.

## Patentansprüche

1. Formgebend umspritzte, elektrische und/oder elektronische Komponente (10), die in einem Formkörper aus festem, thermoplastischem Kunstharz (30) eingebettet ist, das aus einer, unter Niederdruckbedingungen verarbeiteten Hotmelt-Formmasse auf Polyamid-Basis erhalten worden ist, und die mit wenigstens einem, von dem Formkörper abstehenden Befestigungsmittel versehen ist,
**dadurch gekennzeichnet, dass**
dieses Befestigungsmittel aus einem anderen Werkstoff besteht, nämlich aus einem thermoplastischen Formmassen-Werkstoff, der eine Zugfestigkeit (nach DIN 53455) größer 42 N/mm² und einen Elastizitätsmodul (nach DIN 53457) größer 960 N/mm² aufweist.

2. Formgebend umspritzte elektrische und/oder elektronische
Komponente nach Anspruch 1,
**dadurch gekennzeichnet, dass**
dieser thermoplastische Formmassen-Werkstoff eine Zugfestigkeit (nach DIN 53455) größer 54 N/mm² und einen Elastizitätsmodul (nach DIN 53457) größer 1200 N/mm² aufweist.

3. Formgebend umspritzte elektrische und/oder elektronische
Komponente nach Anspruch 1 oder 2,
**dadurch gekennzeichnet, dass**
dieser thermoplastische Formmassen-Werkstoff ein im Spritzgussverfahren verarbeitbares Polyamid, Hart-Polyvinylchlorid, Acetal-Copolymerisat, Polyester oder Polysulfon ist.

4. Formgebend umspritzte elektrische und/oder elektronische
Komponente nach einem der Ansprüche 1 bis 3,
**dadurch gekennzeichnet, dass**
das abstehende Befestigungsmittel ein Stab, ein Stempel, ein Fuß, ein Profilstück, eine Feder für eine Nut/Feder-Verbindung oder ein sonstiges Rastmittel für eine Rastverbindung ist, das an einer angepassten Aufnahme in einem Substrat festlegbar ist.

5. Formgebend umspritzte elektrische und/oder elektronische
Komponente nach Anspruch 4,
**dadurch gekennzeichnet, dass**
das Substrat Innerhalb der Karosserie eines Kraftfahrzeugs angebracht ist.

6. Formgebend umspritzte elektrische und/oder elektronische
Komponente nach einem der Ansprüche 1 bis 5,
**dadurch gekennzeichnet, dass**
das abstehende Befestigungsmittel eine Rastnase (27) ist.

7. Formgebend umspritzte elektrische und/oder elektronische
Komponente nach Anspruch 6,
**dadurch gekennzeichnet, dass**
diese Rastnase (27) einen oder mehrere, einstückig angeformte und elastisch auslenkbare Rastnasenflügel (28, 29) aufweist.

8. Formgebend umspritzte elektrische und/oder elektronische
Komponente nach einem der Ansprüche 1 bis 7,
**dadurch gekennzeichnet, dass**
dieses abstehende Befestigungsmittel, insbesondere diese Rastnase (27) mit einem einstückig angeformten Verankerungselement (32) versehen ist, das in den Formkörper aus fester Hotmelt-Formmasse (30) eingebettet ist.

9. Formgebend umspritzte elektrische und/oder elektronische
Komponente nach Anspruch 8,
**dadurch gekennzeichnet, dass**
dieses Verankerungselement (32) eine geschlossene Schleife (33), oder ein Stab (34) mit einstückig angeformten Querstreben (35) ist, oder ein Fuß (36) mit endständig angeformtem Teller (37) ist, oder ein sich in das Innere des Formkörpers hinein kegelförmig oder kugelförmig erweiternder Körper (38) ist.

10. Formgebend umspritzte elektrische und/oder elektronische
Komponente nach einem der Ansprüche 1 bis 7,
**dadurch gekennzeichnet, dass**
dieses abstehende Befestigungselement, insbesondere diese Rastnase (27) einstückig an einem, aus dem thermoplastischen Formmassen-Werkstoff bestehenden Gehäuseteil (20) angeformt ist, an welchem der Formkörper aus der festen Hotmelt-Formmasse (30) anliegt oder wenigstens teilweise darin eingehaust ist.

11. Formgebend umspritzte elektrische und/oder elektronische
Komponente nach Anspruch 10,
**dadurch gekennzeichnet, dass**
das Gehäuseteil (20) eine im Querschnitt U-förmige Schiene ist.

12. Formgebend umspritzte elektrische und/oder elektronische
Komponente nach einem der Ansprüche 1 bis 12,
**dadurch gekennzeichnet, dass**
die elektrische und/oder elektronische Komponente (10) wenigstens einen Elektrolytkondensator (14) aufweist.

13. Formgebend umspritzte elektrische und/oder elektronische
Komponente nach Anspruch 12,
**dadurch gekennzeichnet, dass**
der Elektrolytkondensator (14) ein Elektrolytkondensator axialer Bauart mit einer axialen Länge größer/gleich 15 mm ist. .

14. Formgebend umspritzte elektrische und/oder elektronische
Komponente nach einem der Ansprüche 1 bis 13,
**dadurch gekennzeichnet, dass**
die Komponente (10) wenigstens eine Spule (11) mit Ferritkem (12) aufweist.

15. Formgebend umspritzte elektrische und/oder elektronische
Komponente nach einem der Ansprüche 1 bis 14,
**dadurch gekennzeichnet, dass**
diese Komponente (10) ein Sperrkreis für ein Heckscheiben-Antennen-System eines Kraftfahrzeugs ist.

16. Formgebend umspritzte elektrische und/oder elektronische Komponente nach einem der Ansprüche 1 bis 15,
**dadurch gekennzeichnet, dass**
die Hotmelt-Formmasse mit einer Schmelzentemperatur von 210 bis 200°C in ein, die zu umspritzende Komponente (10) enthaltendes Moulding-Werkzeug einführbar ist;
innerhalb dieses Moulding-Werkzeuges rasch abgekühlt worden ist; und
die zu umspritzende Komponente (10) mit einer Temperatur im Bereich von 120 bis 140°C kontaktiert.

17. Verfahren zur Herstellung einer formgebend umspritzten elektrischen und/oder
elektronischen Komponente, enthaltend
die Verfahrensschritte
- es wird eine im Querschnitt U-förmige Schiene aus einem thermoplastischen Formmassen-Werkstoff bereitgestellt, der eine Zugfestigkeit (nach DIN 53455) größer 42 N/mm² und einen Elastizitätsmodul (nach DIN 53457) größer 960 N/mm² aufweist, und von deren Rücken bzw. Steg wenigstens ein Befestigungsmittel, insbesondere eine Rastnase absteht, das/die aus dem gleichen Material besteht und dort einstückig angeformt ist;
- in den von der Schiene umgrenzten Hohlraum wird die Komponente eingelegt, deren elektrische Zu- und Ableitungen aus der Schiene herausragen;
- es wird ein verschließbares Moulding-Werkzeug bereitgestellt, das für die Verarbeitung von Hotmelt-Formmassen geeignet ist und das einen angepassten Formhohlraum zur Aufnahme der Schiene mit eingelegter Komponente aufweist;
- die Anordnung aus Schiene mit eingelegter Komponente wird in den Formhohlraum des Moulding-Werkzeugs eingebracht;
- das Moulding-Werkzeug wird verschlossen;
- unter Niederdruckbedingungen wird schmelzflüssige Hotmelt-Formmasse in den von der Schiene umschlossenen Innenraum eingeführt und damit die darin befindliche Komponente umspritzt; und
- nach ausreichender Verfestigung der Hotmelt-Formmasse wird das Moulding-Werkzeug geöffnet, und das Produkt entnommen.

18. Verfahren zur Herstellung einer formgebend umspritzten elektrischen und/oder elektronischen Komponente, enthaltend
die Verfahrensschritte
- es werden einzelne, separate Befestigungsmittel, insbesondere in der Form von Rastnasen bereitgestellt, die je mit einem einstückig angeformten Verankerungselement versehen sind, und die je aus einem thermoplastischen Formmassen-Werkstoff bestehen, der eine Zugfestigkeit (nach DIN 53455) größer 42 N/mm² und einen Elastizitätsmodul (nach DIN 53457) größer 920 N/mm² aufweist;
- es wird ein verschließbares Moulding-Werkzeug bereitgestellt, das für die Verarbeitung von Hotmelt-Formmassen geeignet ist und das einen angepassten Formhohlraum zur Aufnahme der elektrischen und/oder elektronischen Komponente aufweist;
- diese Komponente wird in den Formhohlraum eingelegt und darin in bestimmter Weise angeordnet und festgelegt;
- an einem Werkzeugteil werden das oder die Befestigungsmittel, insbesondere die Rastnase(n) abdichtend so angebracht, dass je deren Verankerungselement nach Verschließen des Werkzeugs in den Formhohlraum hineinragt;
- unter Niederdruckbedingungen wird schmelzflüssige Hotmelt-Formmasse in den Formhohlraum eingeführt und damit die darin befindliche Komponente sowie das/die Verankerungselement(e) umspritzt; und
- nach ausreichender Verfestigung der Hotmelt-Formmasse wird das Moulding-Werkzeug geöffnet, und das Produkt entnommen.

19. Verfahren nach Anspruch 17 oder 18,
**dadurch gekennzeichnet, dass**
ein solches Moulding-Werkzeug verwendet wird, das auf Grund seiner Bauart und auf Grund der Anordnung, der Geometrie und der Größe des Angußkanals oder der Angußkanäle eine rasche Abkühlung der schmelzflüssigen Hotmelt-Formmasse gewährleistet, bevor diese die Komponente kontaktiert.

20. Verfahren nach Anspruch 17 oder 18,
**dadurch gekennzeichnet, dass**
die schmelzflüssige Hotmelt-Formmasse mit einer Temperatur von 210 bis 200°C in das Moulding-Werkzeug eingeführt wird;
Innerhalb dieses Moulding-Werkzeugs rasch auf eine Temperatur im Bereich von 120 bis 140°C abgekühlt wird; und
die Komponente mit dieser Temperatur kontaktiert.

21. Verfahren nach einem der Ansprüche 17 bis 20,
**dadurch gekennzeichnet, dass**
ein Moulding-Werkzeug verwendet wird, das aus einer Al/Cu-Legierung besteht, die bis zu 1,5 % Cu enthält.

22. Zwischenprodukt zur Verwendung bei einem Verfahren nach Anspruch 17, wobei
eine im Querschnitt U-förmige Schiene, von deren Rücken bzw. Steg wenigstens ein Befestigungsmittel, insbesondere eine Rastnase absteht, das/die aus dem gleichen Material besteht und dort einstückig angeformt ist; und
diese Schiene zusammen mit dem Befestigungsmittel/der Rastnase oder den Rastnasen aus einem thermoplastischen Formmassen-Werkstoff besteht, der eine Zugfestigkeit (nach DIN 53455) größer 42 N/mm² und einen Elastizitätsmodul (nach DIN 53457) größer 960 N/mm² aufweist.

## Claims

1. A shapingly moulded-in electrical and/or electronical component (10) embedded within a moulded part made of a solid thermoplastic resin (30) obtained from a hot melt moulding compound based on polyamides and workable at low-pressure conditions, and
this component (10) comprising at least one fastening means extending from said moulded part,
**characterized in that**
said fastening means is consisting of another material, that is a thermoplastic moulding material having a tensile strength (according to DIN 53455) larger than 42 N/mm² and further having a modulus of elasticity (according to DIN 53457) larger than 960 N/mm².

2. The shapingly moulded-in electrical and/or electronical component according to claim 1,
**characterized in that**
said thermoplastic moulding material comprises a tensile strength (according to DIN 53455) larger than 54 N/mm² and further comprises a modulus of elasticity (according to DIN 53457) larger than 1200 N/mm².

3. The shapingly moulded-in electrical and/or electronical component according to claim 1 or 2,
**characterized in that**
said thermoplastic moulding material comprises a polyamide workable according to the injection moulding process, or comprises a rigid poly(vinyl chloride), an acetal copolymer, a polyester or a polysulfone.

4. The shapingly moulded-in electrical and/or electronical component according to anyone of the claims 1 to 3,
**characterized in that**
said extending fastening means comprises a pin or rod, a head or stamp, a foot, a profiled piece, a tongue of a groove and tongue connection device or another detent latch, pin or spring of a snap-in locking device which detent latch, pin or spring may be locked at an adapted retainer formed within a substrate.

5. The shapingly moulded-in electrical and/or electronical component according to claim 4,
**characterized in that**
said substrate is located within an automotive body.

6. The shapingly moulded-in electrical and/or electronical component according to anyone of the claims 1 to 5,
**characterized in that**
said extending fastening means comprises a snapping head (27).

7. The shapingly moulded-in electrical and/or electronical component according to claim 6,
**characterized in that**
said snapping head (27) comprises one or several resiliently deflectable spring arms (28, 29) formed integrally with said snapping head (27).

8. The shapingly moulded-in electrical and/or electronical component according to anyone of the claims 1 to 7,
**characterized in that**
said extending fastening means, especially said snapping head (27) is provided with an integrally formed anchoring element (32);
and said anchoring element (32) is embedded within the moulded part made of said hot melt moulding compound (30).

9. The shapingly moulded-in electrical and/or electronical component according to claim 8,
**characterized in that**
said anchoring element (32) comprises a closed loop (33), or a rod (34) having integrally formed crossbars (35), or a foot (36) having a distantly formed disk (37), or a member (38) extending conically or spherically into the body of the moulded part.

10. The shapingly moulded-in electrical and/or electronical component according to anyone of the claims 1 to 7,
**characterized In that**
said extending fastening means, especially said snapping head (27) is integrally formed with a part of case (20) consisting of said thermoplastic moulding material, whereis said moulded part formed of said solid hot melt moulding compound (30) is contacting said part of case (20) or is at least partly housed within said part of case (20).

11. The shapingly moulded-in electrical and/or electronical component according to claim 10,
**characterized in that**
said part of case (20) comprises a track having a U-shaped cross-sectional area.

12. The shapingly moulded-in electrical and/or electronical component according to anyone of the claims 1 to 11,
**characterized in that**
said electrical and/or electronical component (10) comprises at least one electrolytic capacitor (14).

13. The shapingly moulded-in electrical and/or electronical component according to claim 12,
**characterized in that**
said electrolytic capacitor (14) comprises an electrolytic capacitor of axial type having an axial length larger than or equal 15 mm.

14. The shapingly moulded-in electrical and/or electronical component according to anyone of the claims 1 to 13,
**characterized in that**
said component (10) comprises at least one coil (11) equipped with a ferrite core (12).

15. The shapingly moulded-in electrical and/or electronical component according to anyone of the claims 1 to 14,
**characterized in that**
said component (10) forms a stopper circuit for an automotive rear window antenna system.

16. The shapingly moulded-in electrical and/or electronical component according to anyone of the claims 1 to 15,
**characterized in that**
said hot melt moulding compound is capable to form a melt having a melt temperature of from 210°C to 200°C when being introduced into a moulding tool containing said component (10) to become moulded-in;
said hot melt moulding compound is rapidly cooled within said moulding tool; and said hot melt moulding compound having a temperature in the range of from 120°C to 140°C when contacting said component (10) to become moulded-in.

17. A method of manufacturing a shapingly moulded-in electrical and/or electronical component,
said method comprises the following steps:
- providing a track, having a U-shaped cross-sectional area and comprising a back or web; and
made of a thermoplastic moulding material having a tensile strength (according to DIN 53445)) larger than 42 N/mm² and further having a modulus of elasticity (according to DIN 53457) larger than 960 N/mm²; and
at least one fastening means, especially a snapping head, each made of the same material than said track, is integrally formed with said back or web and is extending therefrom;
- inserting the component into a hollow space defined by said track in such a manner that electrical lines connected with said component are projecting out of said track;
- providing a lockable moulding tool suited for processing hot melt moulding compounds, and comprising a cavity adapted for an introduction of said track including said inserted component;
- arranging said track Including said inserted component within said cavity of said moulding tool;
- closing said moulding tool;
- introducing molten hot melt moulding compound at low-pressure conditions into the hollow space defined by said track and moulding-in the component contained in said hollow space; and
- allowing a sufficient solidification of the hot melt moulding compound; then opening the moulding tool; and
then removing the product therefrom.

18. A method of manufacturing a shapingly moulded-in electrical and/or electronical component,
said method comprises the following steps:
- providing single separate fastening means, especially fastening means comprising a snapping head, and each fastening means comprising an integrally formed anchoring element, and
each fastening means made of a thermoplastic moulding material having a tensile strenght (according to DIN 53445) larger than 42 N/mm₂ and further having a modulus of elasticity (according to DIN 53457) larger than 920 N/mm²;
- providing a lockable moulding tool suited for processing hot melt moulding compounds, and comprising a cavity adapted for an introduction of said electrical and/or electronical component;
- arranging and fixing said component in a definite manner within said cavity;
- attaching one or several fastening means, especially one or several snapping head(s) in a sealing manner to a moulding tool such that the anchoring element(s) thereof is/are projecting into the cavity, subsequently to a locking of said moulding tool;
- introducing molten hot melt moulding compound at low-pressure conditions into the cavity and moulding-in the component and the anchoring element(s) contained therein; and
- allowing a sufficient solidification of the hot melt moulding compound; then opening the moulding tool; and
then removing the product therefrom.

19. The method according to claim 17 or 18,
**characterized in that**
using such a moulding tool, which due to its design and construction, and due to the arrangement, the geometry and the size of the runner(s), allow a rapid cooling of the molten hot melt moulding compound before this compound will contact the component.

20. The method according to claim 17 or 18,
**characterized in that**
said molten hot melt moulding compound having a temperature of from 210°C to 200°C when being introduced into the moulding tool;
said molten hot melt moulding compound is rapidly cooled within said moulding tool to a temperature in the range of from 120°C to 140°C; and
said molten hot melt moulding compound having the latter temperature when contacting the component.

21. The method according to anyone of the claims 17 to 20,
**characterized in that**
using a moulding tool consisting of a Al/Cu alloy containing up to 1.5 % copper.

22. Intermediate product for use along with a method according to claim 17,
**wherein**
comprising a track having a U-shaped cross-sectional area, and further having a back or web;
at least one fastening means, especially a snapping head is integrally formed with said back or web, is projecting therefrom; and
is made from the same material than said track; and
said track and the fastening means, especially the snapping head(s) are consisting of a thermoplastic moulding material having a tensile strength (according to DIN 53455) larger than 42 N/mm² and further having a modulus of elasticity (according to DIN 53457) larger than 960 N/mm².

## Revendications

1. Un composant électrique et/ou électronique (10) façonné par scellement qui est noyé dans une pièce moulée en résine thermoplastique solide (30) obtenue d'une matière moulable thermofusible à base de polyamides façonnée sous conditions de basse pression,
ce composant (10) étant muni d'au moins un moyen de fixation saillant de la pièce moulée
**caractérisé en ce que**
le(s) moyen(s) de fixation se compose(nt) d'une autre matière, notamment d'une matière moulable thermoplastique, dont la résistance à la traction (conformément à DIN 53455) est supérieure à 42 N/mm² et le module d'élasticité (conformément à DIN 53457) est supérieur à 960 N/mm².

2. Un composant électrique et/ou électronique façonné par scellement
conformément à la revendication 1,
**caractérisé en ce que**
la matière moulable thermoplastique a une résistance à la traction (conformément à DIN 53455) supérieure à 54 N/mm² et un module d'élasticité (conformément à DIN 53457) supérieur à 1200 N/mm².

3. Un composant électrique et/ou électronique façonné par scellement conformément à la revendication 1 ou 2,
**caractérisé en ce que**
la matière moulable thermoplastique est un polyamide, un chlorure de polyvinyle dur, un acétal copolymérisat, un polyester ou un polysulfone pouvant être façonné selon le procédé de moulage par injection.

4. Un composant électrique et/ou électronique façonné par scellement conformément à une des revendications 1 à 3,
**caractérisé en ce que**
le moyen de fixation saillant est une broche ou barre, un poinçon, un pied, une pièce profilée, une languette d'un assemblage languette et rainure ou un autre moyen d'arrêt pouvant s'encliqueter dans un dispositif à crans, qui peut être verrouillé dans un logement y adapté dans un substrat.

5. Un composant électrique et/ou électronique façonné par scellement conformément à la revendication 4,
**caractérisé en ce que**
le substrat se trouve à l'intérieur d'une carrosserie de véhicule.

6. Un composant électrique et/ou électronique façonné par scellement conformément à une des revendications 1 à 5,
**caractérisé en ce que**
le moyen de fixation saillant est un nez à crans (27).

7. Un composant électrique et/ou électronique façonné par scellement conformément à la revendication 6,
**caractérisé en ce que**
le nez à crans (27) présente un ou plusieurs ailes de nez (28, 29) solidaires au nez à crans (27) qui peuvent être déployées de manière élastique.

8. Un composant électrique et/ou électronique façonné par scellement conformément à une des revendications 1 à 7,
**caractérisé en ce que**
le moyen de fixation saillant, notamment le nez à crans (27) est muni d'un moyen d'ancrage (32) solidaire au nez à crans, ce moyen d'ancrage (32) étant noyé dans la pièce moulée en matière moulable thermofusible (30).

9. Un composant électrique et/ou électronique façonné par scellement conformément à la revendication 8,
**caractérisé en ce que**
le moyen d'ancrage (32) est une boucle fermée (33) ou une barre (34) ayant des entretoises (35) solidaires à la barre (34), ou un pied (36) à l'extrémité duquel se trouve un disque (37), ou un élément (38) qui s'élargit à l'intérieur de la pièce moulée de manière conique ou sphérique.

10. Un composant électrique et/ou électronique façonné par scellement conformément à une des revendications 1 à 7,
**caractérisé en ce que**
le moyen de fixation saillant, notamment le nez à crans (27) est solidaire à une partie du boîtier (20) en la matière moulable thermoplastique, et que la pièce moulée (30) en matière thermofusible solide est contiguë au boîtier (20) ou se trouve au moins partiellement noyée dans le boîtier (20).

11. Un composant électrique et/ou électronique façonné par scellement conformément à la revendication 10,
**caractérisé en ce que**
la partie du boîtier (20) est un rail à section en U.

12. Un composant électrique et/ou électronique façonné par scellement conformément à une des revendications 1 à 11,
**caractérisé en ce que**
le composant électrique et/ou électronique (10) comprend au moins un condensateur électrolytique (14).

13. Un composant électrique et/ou électronique façonné par scellement conformément à la revendication 12,
**caractérisé en ce que**
le condensateur électrolytique (14) est un condensateur électrolytique du type axial dont la longueur axiale est supérieure ou égale à 15 mm.

14. Un composant électrique et/ou électronique façonné par scellement conformément à une des revendications 1 à 13,
**caractérisé en ce que**
le composant (10) comprend au moins une bobine (11) à noyau en ferrite (12).

15. Un composant électrique et/ou électronique façonné par scellement conformément à une des revendications 1 à 14,
**caractérisé en ce que**
le composant (10) est un filtre d'arrêt d'un système d'antenne de lunette arrière d'un véhicule.

16. Un composant électrique et/ou électronique façonné par scellement conformément à une des revendications 1 à 15,
**caractérisé en ce que**
la matière moulable thermofusible peut être introduite à une température entre 210°C et 200°C dans un outil de moulage qui comprend le composant (10) à sceller ;
que la matière moulable thermofusible est rapidement refroidie ; et qu'elle a une température dans la plage entre 120°C et 140°C lorsqu'elle entre en contact avec le composant (10) à sceller.

17. Procédé pour la production d'un composant électrique et/ou électronique façonné par scellement,
**comprenant les étapes suivantes :**
- Mettre à disposition un rail à section en U en matière moulable thermoplastique dont la résistance à la traction (conformément à DIN 53455) est supérieure à 42 N/mm² et le module d'élasticité (conformément à DIN 53457) est supérieur à 960 N/mm² ; et dont le dos ou l'âme est solidaire à au moins un moyen de fixation, notamment un nez à crans saillant qui est composé de la même matière que le rail ;
- insérer le composant dans la cavité entourée par le rail de manière que les lignes électriques débordent le rail ;
- mettre à disposition un outil de moulage verrouillable adapté au façonnage de matières moulables thermofusibles et qui comprend une cavité conçue pour recevoir le rail avec le composant mis en place ;
- mettre en place le rail avec le composant mis en place, dans la cavité
de l'outil de moulage ;
- fermer l'outil de moulage ;
- introduire la matière moulable thermofusible en fusion sous conditions de basses pressions dans la cavité entourée par le rail et sceller ainsi le composant se trouvant dans cette cavité ;
- attendre la solidification suffisante de la matière moulable thermofusible ;
ouvrir l'outil de moulage retirer le produit.

18. Procédé pour la production d'un composant électrique et/ou électronique façonné par scellement,
**comprenant les étapes suivantes :**
- Mettre à disposition des moyens de fixations seuls séparés, notamment sous forme de nez à crans qui sont chacun munis d'un moyen d'ancrage solidaire au nez à crans, dont chacun est en matière moulable thermoplastique dont la résistance à la traction (conformément à DIN 53455) est supérieure à 42 N/mm² et le module d'élasticité (conformément à DIN 53457) est supérieur à 960 N/mm² ;
- mettre à disposition un outil de moulage verrouillable adapté au façonnage de matières moulables thermofusibles qui comprend une cavité conçue pour recevoir le composant électrique et/ou électronique ;
- insérer le composant dans la cavité servant de moule et l'arranger et le bloquer d'une manière définie ;
- attacher le ou les moyen(s) de fixation notamment le(s) nez à crans de manière étanche à une partie de l'outil de moulage de sorte que son (leur) moyen(s) de fixation est (sont) en saillie dans la cavité servant de moule après que l'outil de moulage est fermé ;
- introduire la matière moulable thermofusible en fusion sous conditions
de basses pressions dans la cavité servant de moule et sceller ainsi le
composant et le(s) moyen(s) d'ancrange se trouvant dans cette cavité ;
- attendre la solidification suffisante de la matière moulable thermofusible ;
ouvrir l'outil de moulage et retirer le produit.

19. Procédé conformément à la revendication 17 ou 18,
**caractérisé par**
l'emploi d'un outil de moulage qui assure en raison de sa conception et son arrangement, la géométrie et la taille du canal ou des canaux de carotte un refroidissement rapide de la matière moulable thermofusible en fusion avant qu'elle n'entre en contact avec le composant.

20. Procédé conformément à la revendication 17 ou 18,
**caractérisé en ce que**
la matière moulable thermofusible en fusion est introduite à une température entre 210°C et 200°C dans l'outil de moulage ;
que la matière moulable thermofusible est rapidement refroidie à l'intérieur de l'outil de moulage à une température dans la plage entre 120°C et 140°C ; et qu'elle a cette température lorsqu'elle entre en contact avec le composant.

21. Procédé conformément à une des revendications 17 à 20,
**caractérisé par**
l'emploi d'un outil de moulage composé d'un alliage Al-Cu comprenant jusqu'à 1,5 % de Cu.

22. Produit intermédiaire à utiliser lors d'un procédé conformément à la revendication 17,
**caractérisé par**
un rail à section en U dont le dos ou l'âme est solidaire à au moins un moyen de fixation, notamment un nez à crans saillant qui est composé de la même matière que le rail ; ce rail ensemble avec le moyen de fixation / le ou les nez à crans se composant d'une matière moulable thermoplastique, dont la résistance à la traction (conformément à DIN 53455) est supérieure à 42 N/mm² et le module d'élasticité (conformément à DIN 53457) est supérieur à 960 N/mm².
